# EUROPEAN PATENT SPECIFICATION

(11) **EP 1 126 614 B1**
(45) Date of publication and mention of the grant of the patent: **17.11.2004**
(21) Application number: 00830102.0
(22) Date of filing: 14.02.2000
(51) Int. Cl.: H03K 19/177

(54) **Programmable logic arrays**
Programmierbare logische Felder
Réseaux logiques programmables

(43) Date of publication of application: 22.08.2001
(73) Proprietor: STMicroelectronics S.r.l., 20041 Agrate Brianza (Milano) (IT)
(72) Inventor: Ghezzi, Stefano, 24048 Treviolo (IT); Ferrario, Donato, 20061 Carugate (IT); Yero, Emilio, 20059 Vimercate (IT); Campardo, Giovanni, 24128 Bergamo (IT)
(74) Representative: Pellegri, Alberto

(56) References cited:
- EP-A- 0 254 474
- US-A- 4 661 728
- US-A- 4 725 745
- US-A- 4 760 290

## Description

### FIELD OF THE INVENTION

The present invention relates in general to reprogrammable memories and more in particular to a new programmable logic array comprising at least an AND plane and an eventual OR plane.

### BACKGROUND OF THE INVENTION

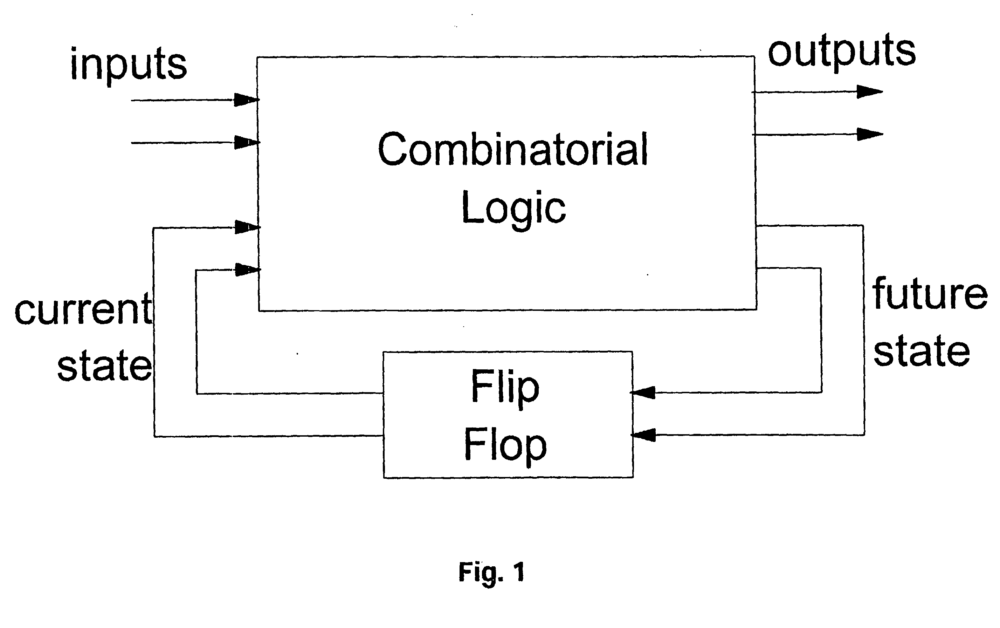

The design of logic circuitry may sometimes deal with complex combinatorial circuitry which depend on a clock signal. For example, this may be the case of a states machine that implements a sequential algorithm that may have the combinatorial part separated from the sequential storage. Figure 1 shows a basic scheme of a states machine.

Current design approaches contemplate the description of the states machine in a high level language (for example VHDL) in order to devise the algorithm. Once the methods are described in a language that may be synthesized, i.e.: a high level language that can be interpreted by software in order to automatically synthesize the described logic network, the combinatorial circuitry can be either realized with elementary logic gates or with a programmable logic array or briefly PLA. The two solutions have their own advantages and disadvantages whose details are beyond the scope of the ensuing description. What may be emphasized is that the realization of logic gates is a must and as a consequence the algorithm may not be modified in a simple manner, in fact if a logic gate is to be modified with CMOS technology there is a need to modify the masks that allow for the realization of at least s transistor including the mask of the active areas that is used during the first process step. On the other hand, by using a PLA (Programmable Logic Array) the algorithm may be completely changed in a simple way by using a very limited number of masks and therefore of process steps.

In other cases, such as that of FLASH EPROM memories, the reprogrammability factor is very important because sometimes the algorithm requires some changes or updating during the life span of the device. This may occur during the debug phase or may follow specific requisites which were not envisaged at the time of designing the device.

Due to their relevance in the present contact, the ensuing description will make reference to FLASH EPROM memories, even though the invention may as well be applied to re-programmable memories of a different type.

The document US-A-4,661,728 discloses a CMOS programmable logic array (PLA) circuit including a product term array and a sum term array coupled by a control transistor. The gate electrode of the control transistor is coupled to an output of the product term array and a source (or drain) electrode is coupled to an input end of the sum term array. N-channel type transistors are employed in the product term and the sum term arrays while a P-channel type transistor is employed as control transistor.

The document US-A-4,725,745 describes a programmable logic array wherein the logical product gate array is composed of a plurality of field effect transistors, the gates of which are selectively driven by a plurality of input signals and the source-drain paths of these transistors are connected in series. The logical summation gate array employs a plurality of inverted bipolar junction transistors with collector-emitter paths connected in parallel.

The document EP-A-0 254 474 describes a programmable CMOS logic array including a dynamic AND plane and an OR plane using clocked load devices. A single clock provided with a delay path may be used to control the precharge and decode operations.

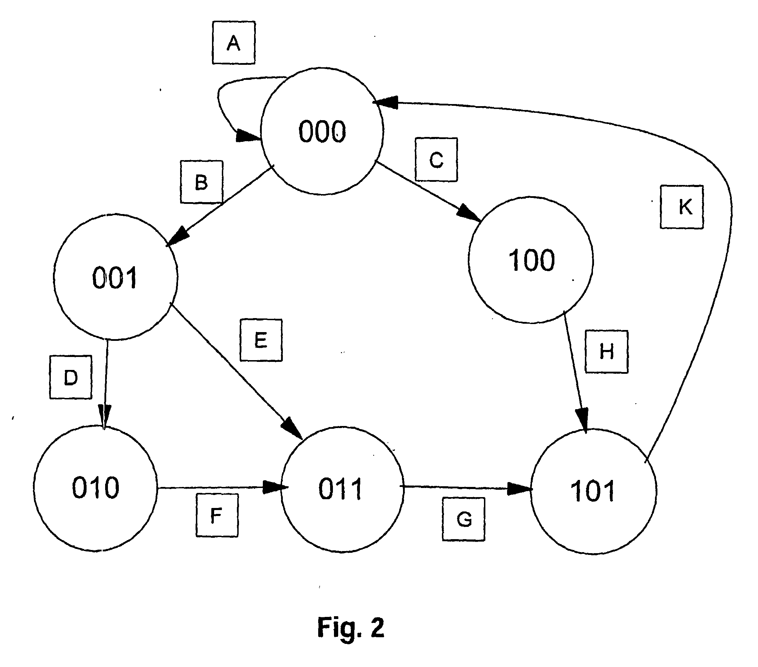

In order to clarify the technical problem overcame by the invention let us refer to Fig 2. The nodes of the orientated graph represent the states of the machine. Three bits individuate these states, whereas the branches labeled with the letters represent the state transitions.

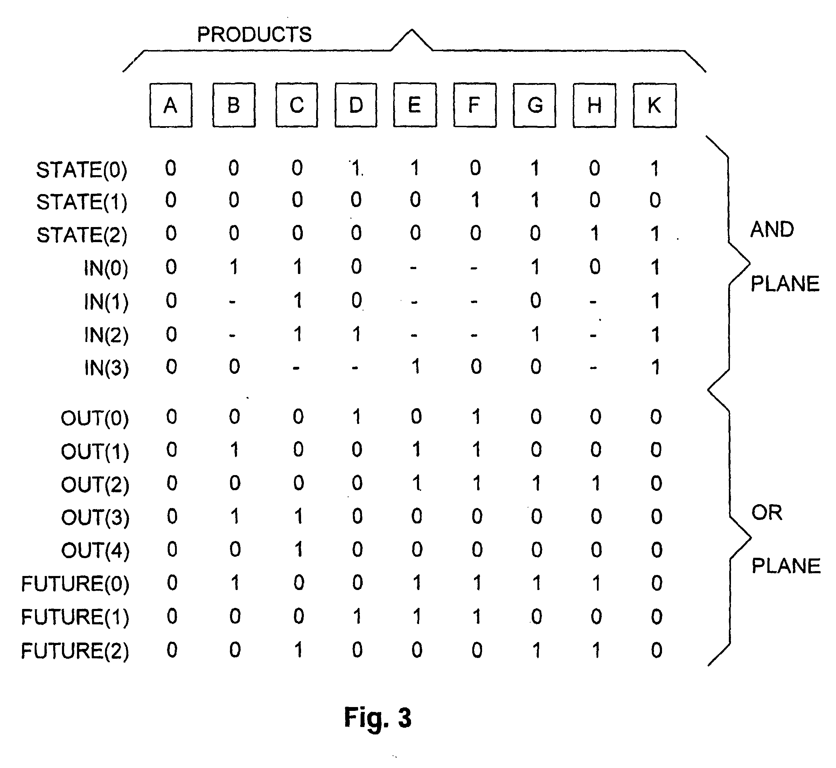

The truth table of the machine of Fig. 2 is shown in Fig. 3. The states of the machine are coded by the variable STATE(0), STATE(1) e STATE(2) which represent the least significative bit, the intermediate bit and the most significative bit of the group of three bits that individuate a certain current state. The variables FUTURE(0), FUTURE(1) and FUTURE(2) represent the least significative bit, the intermediate bit and the most significative bit, respectively, of the group of three bits that individuate a future state reached as a result of a certain transition. The variables OUT(.) e IN(.) represent the bits of the logic input and output logic signals of the machine corresponding to a certain transition. The dashes "-represent "don't care symbols".

A hardware embodiment by the use of a programmable logic array (PLA) of the truth table of Fig. 3 is shown in Figures 5 and 6. The considered PLA is built according to an AND-OR pre-charge and valuation scheme. The combinatory circuitry, COMBINATORIAL LOGIC, that implements it has 7 inputs, 9 minterms and 8 outputs.

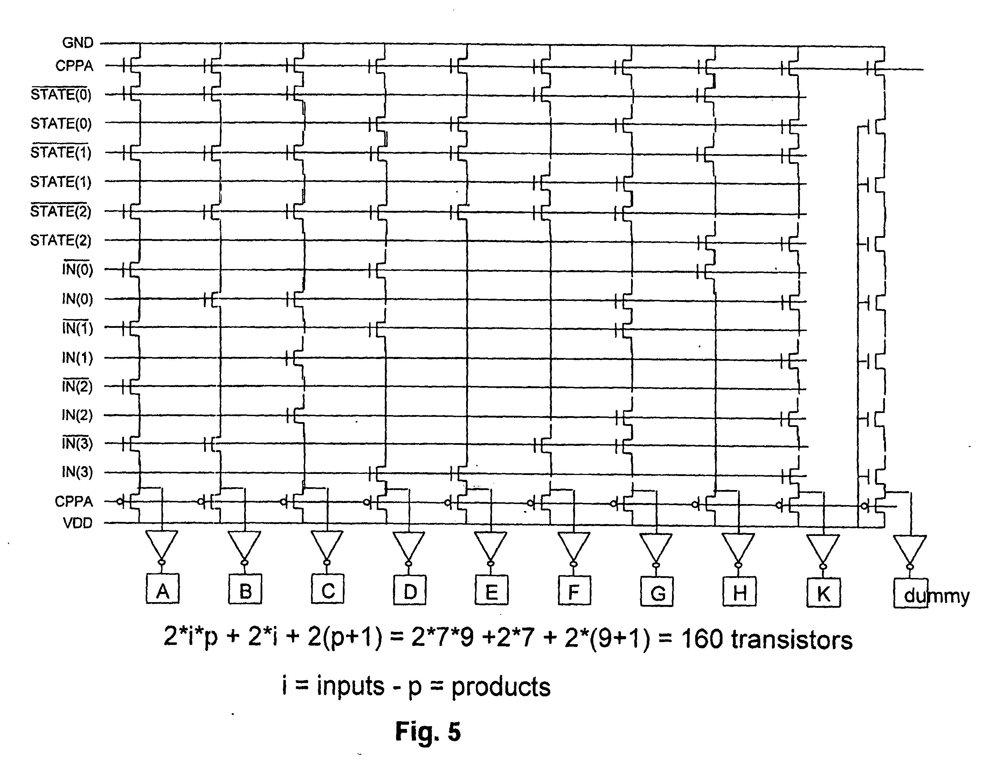

As it may be noticed, the AND plane of the PLA of Fig. 5 is constituted by an array of transistors ordered in rows and columns. The transistors of a same column are connected in series through their respective current terminals, whereas the control terminals of the transistors belonging to the same row are connected in parallel.

The top row of the array serves to drive the start-up of the processing, whereas the bottom row serves to extract the computed values once the processing is completed.

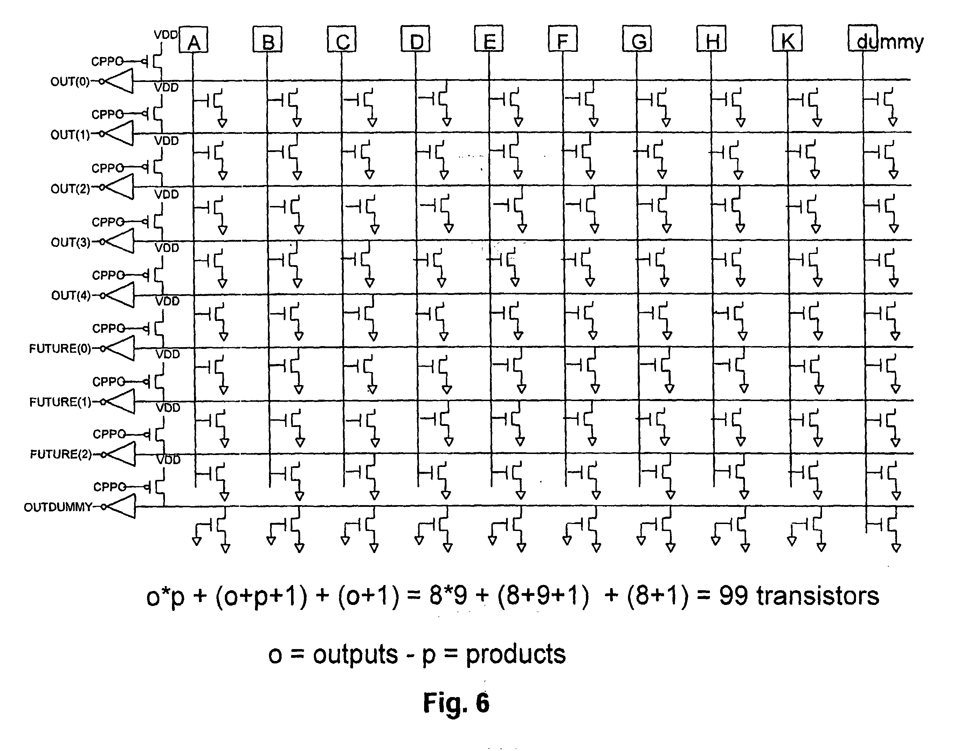

The OR plane of the PLA, shown in Fig. 6, is instead constituted by an array of transistors organized in row and columns which carry out the logic sum of the input minterms and by an output buffer.

The transistors that belong to the same column of the array have their control terminals connected to a respective control line coupled to a certain minterm, a first current terminal connected to a reference potential, and the transistors of a same row have their second current terminal either connected or not to a respective output line.

The output buffer, which in the cited figure appears on the left hand side, is constituted by a column of inverters each of which is connected to a respective output line and to a respective enabling transistor connected between the respective output line and the supply voltage VDD.

The PLA is a pre-charge and evaluation circuit, that is, the internal nodes are first pre-charged and then discharged during the evaluation phase if the input pattern corresponds to the expected one.

To ensure that the outputs are read at the instant they assume a valid value, that is, only when all the transistors function in a steady state, the PLA is provided with a dummy path (DUMMY), as depicted in Figures 5 and 6, designed to be the slowest of all. This path (DUMMY) is constituted by a set of as many transistors as the number of independent logic variables needed to realize the machine.

Because the dummy path has the largest number of transistors amongst the various paths of the PLA, it will consequently be also the slowest to reach a steady state of operation. Therefore, when a signal propagates through all the dummy path's transistors, surely all the other input signals will have propagated through their respective paths and thereby the evaluation phase may be completed.

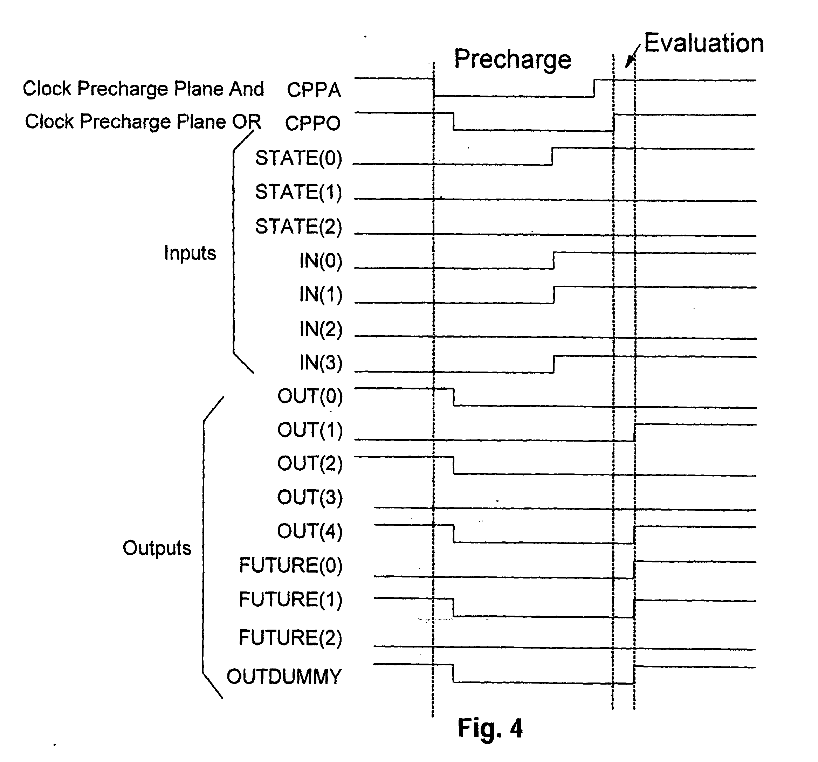

A possible temporal diagram of the signals relative to the logic variables of the table of Figure 3 relative to the "E" transition is shown in Fig. 4. The pre-charge phases of the AND (CPPA) and OR (CPPO) plane are active low and are out-phased among them so that the output of the AND plane of the PLA may have reached a steady state before the start of the processing carried out by the OR plane of the PLA.

Before the CPPA signal enables the AND plane, the variables STATE(.) and IN(.) assume their respective values. Once the charge phase is completed with the disabling of the CPPO signal, the outputs OUT(.) and FUTURE(.) assume their respective final values, which are read only when the DUMMY path reaches a steady state and has delivered an OUTDUMMY output signal.

As clearly shown in Figures 5 and 6, a combinatorial network having an "i" number of input variables may be realized with a PLA with 2^{*}I inputs, that is, the "i" input variables plus their respective inverted logic signal. This occurs because in order to ensure the programmability of the PLA the input variables and the respective inverted logic signals should be available.

Let us consider a PLA with 2^{*}I inputs, "p" minterms and "o" outputs and let us also suppose to realize a AND-OR PLA. To realize the AND plane on silicon there must be enough space for:
- 2*i*p transistors for the content;
- 2*i transistors for the DUMMY PATH;
- 2*(p+1) for the pre-charge of the minterms;
- p inverters.

In order to realize an OR plane there must be enough silicon area for:
- o*p transistors for the content;
- o+p+1 transistors for the DUMMY PATH;
- o+1 for the pre-charge of the minterms;
- o+1 inverters.

In figure 5 different space intervals between the transistors of a same column are depicted as if at some of the locations there were transistors while at other locations there were only a short-circuit. In reality, the transistors of the PLA are uniformly distributed on the silicon surface. However, only those transistors that do not concur to form a certain minterm are short-circuited and are depicted in the figure as simple short-circuits, whereas the transistors corresponding to the variables present in a certain minterm have been depicted.

All these transistors may have minimum dimensions because they are designed for a specific requirement in a restricted area, therefore with a small parasite load.

The reprogramming process is realized by modifying the connection of only one terminal of the transistors of the AND plane and of the OR plane.

In the AND plane, the gate of the transistors is depicted in correspondence of the true signal ("1" in the truth table) and of the inverted signal ("0" in the truth table), while it is not shown at all in correspondence of "don't cares" ("-" in the truth table).

In the OR plane the transistors are depicted omitting some of the contacts that connect them to the output line. The contacts are either shown if the output is conditioned by the minterm considered ("1" in the truth table) or not if the minterm does not concur to the output line ("0" in the truth table).

In summary, in this type of PLA, a reprogramming of the entire algorithm may be implemented by establishing or not certain connections using poly gate and contact masks.

Currently used architectures have several drawbacks.

As discussed above, the AND plane requires a silicon area of 2*i*p transistors for the logic content of the plane. However, it is evident that to realize any minterm there is not the need for "i" inputs because an input and its logic inverted value are never used simultaneously in the same minterm. A silicon area of i*p transistors should be theoretically sufficient to realize any minterm. Therefore, there exists a silicon area reserved to i*p transistors that remains always unused.

A second drawback relates to the fact that the drain nodes of the unused transistors of the OR plane remain floating, a condition that should be avoided in VLSI circuits.

A third problems relates to the requisite of two distinct masks to reprogram this type of PLA, one mask for the AND plane and another one for the OR plane, while it would be certainly more cost effective to use the same mask for both planes.

Finally, the dummy path serves solely to know when to read the PLA outputs, because the different paths are characterized by different signal propagation times.

Therefore, there exist a need for a PLA that besides overcoming all the above-described drawbacks has signal propagation times along the various paths that are independent from the specific programming of the PLA, thus permitting to eliminate the need to implement a dummy path and thereby further reducing the area requisite.

### OBJECT AND SUMMARY OF THE INVENTION

It has now been found and is the object of the present invention a novel architecture for an AND plane of a logic programmable array (PLA) that eliminates all the above-noted drawbacks of known PLAs.

The CMOS logic programmable array (PLA) of the invention has at least an AND plane comprising an array of transistors arranged in rows and columns. The transistors belonging to a same column are electrically in series and the opposite end current terminals of the series of transistors are coupled to a supply voltage (VDD) and to a reference potential (GND), respectively, and the transistors of the first row and of the last row of the array have their control terminals connected to respective enabling potentials.

The peculiarity of the PLA of the invention is that with the exception of the two extreme rows, each other row of the array is associated to three different control lines. A first line is coupled to a first input value, the second line is coupled to the logic inverted value of the first input value, and the third line is coupled to a potential that maintains in a state of conduction the transistors connected to it, each transistor of each non-extreme row has its control terminal connected to one of the three control lines.

Optionally, the AND plane of the PLA of the invention may have a column (DUMMY) of transistors the control terminals which with the exception of the transistors belonging to the two extreme rows are coupled to a voltage that maintains them in a conduction state.

According to a non-claimed example, a logic programmable array (PLA) may have at least an OR plane comprising an array of transistors arranged in rows and columns. The transistors belonging to a same column have their control terminals connected to a respective control line and a first current terminal coupled to a reference voltage (GND), each transistor of each row of the array having a second current terminal connected or not to a respective output line, and those not connected to a respective output line are short-circuited to the respective first current terminal.

The OR plane of the PLA may optionally have a column (DUMMY) of transistors whose control terminals are connected to a respective control line while the current terminals are coupled to the reference potential (GND).

### BRIEF DESCRIPTION OF THE DRAWINGS

The different aspects and advantages of the invention will be even more evident through the following description of few embodiments and upon referring to the attached drawings wherein:
**Figure 1** is a basic scheme of a finite states machine;
**Figure 2** shows a sample transitions diagram of a finite states machine
**Figure 3** is the truth table of the machine of Fig. 2;
**Figure 4** shows a possible temporal diagram of the signals involved in the "E" transition of Fig. 2;
**Figure 5** shows the AND plane of a known PLA that implements the machine of Fig. 2;
**Figure 6** shows the OR plane of a known PLA that implements the machine of Fig. 2;

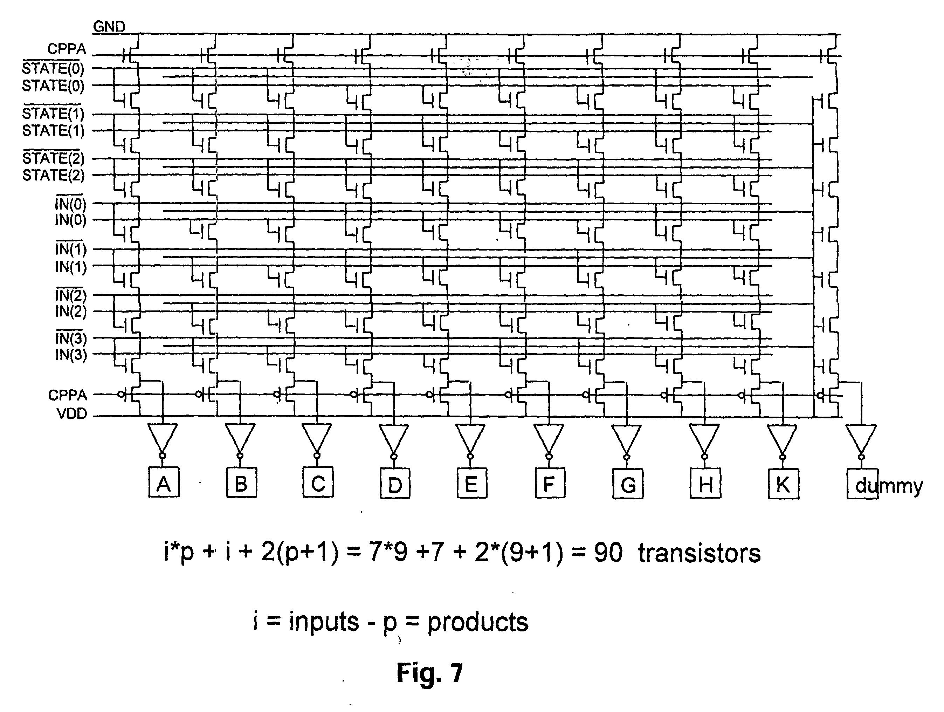

**Figure 7** shows the AND plane of a PLA of the invention that implements the machine of Fig. 2;

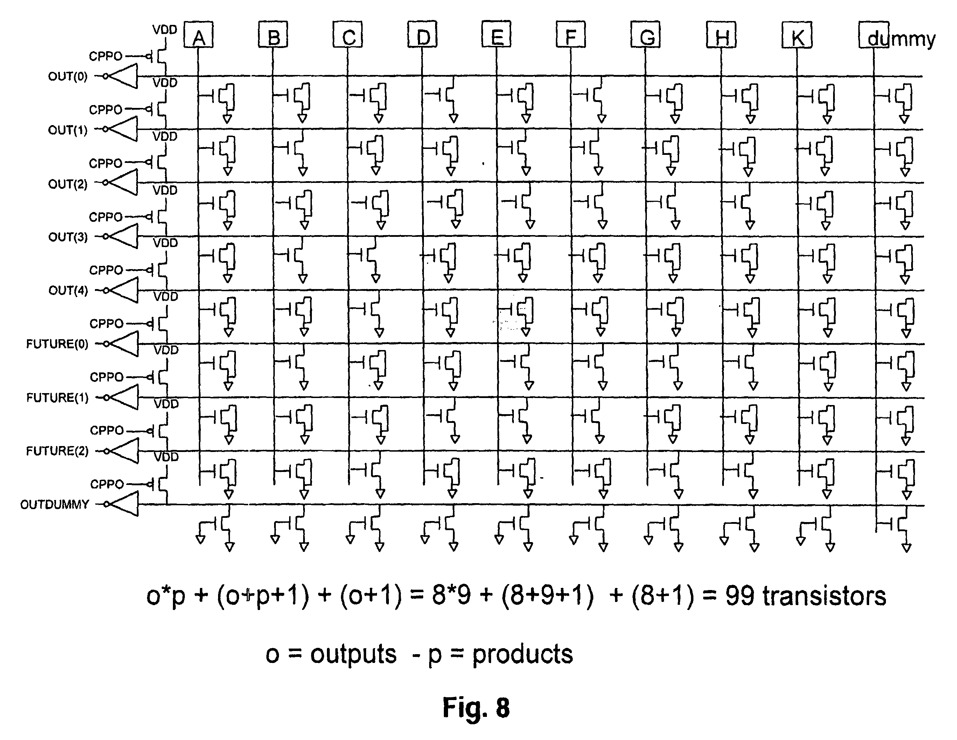

**Figure 8** shows the OR plane of a PLA that implements the machine of Fig. 2.

### DESCRIPTION OF FEW EMBODIMENTS OF THE INVENTION

According to this invention, a PLA containing at least an AND plane can be made with a reduced silicon area requisite.

The AND plane of a PLA of the invention, instead of having a transistor on an input line or on the inverted input line, or no transistor at all, there is a unique transistor whose gate is either connected to the input line or to the inverted input line, or to the supply node (in which case the transistor is kept in a conduction state), as highlighted in Fig. 7. Hence, the AND plane requires a silicon area of integration sufficient for:
- i*p transistors for the content.
- 2^{*}i transistors for the DUMMY path.
- 2^{*}(p+1) for the pre-charge of the minterms
- p inverters.

The logic content requires a silicon area for i*p transistors rather than 2*i*p transistors as in the PLAs of the prior art. Therefore, for the same area occupied by each transistor, and for implementing a certain Boolean function, the PLA of the invention, occupies less space than a known PLA.

A further advantage is that each column of the AND plane counts the same number of transistors in series, and thereby each minterm requires the same time to be valuated. This guarantees that all the outputs reach their final value practically at the same instant. This may even permit (if so desired) to realize a simple and convenient external timing instead of a more burdensome DUMMY path.

A PLA realized with such an AND plane may be reprogrammed through the first metalization level.

In the OR plane of the PLA of the non-claimed example the unused transistors have their drain and source short-circuited to each other and coupled to ground, as highlighted in Fig. 8.

Therefore, contrarily to what occurs in known PLA, the presence of floating potentials is averted.

As the plane AND also the OR plane may also be reprogrammed through the first metalization level and therefore the PLA of the invention may be reprogrammed with only one mask.

Beside the circuit of Figures 7 and 8, it is also possible to realize PLAs of a different type than the AND/OR type, for example AND/AND.

Moreover, pre-charge and valuation PLAs may be realized with a single AND plane.

In summary, the advantages of the novel architecture of the invention are threefold: area of integration on silicon, cost and performance.

The new PLA occupies undoubtedly less space than known PLAs for the same combinatorial logic.

The use of only one mask in the reprogramming process reduces the whole costs of adjustment of the content. Moreover, such a mask is one of the last masks that are used in the fabrication process and is relatively easy to make.

The performances of a PLA of the invention are better than those of a PLA. Indeed, in known PLAs the timing is based on a DUMMY path, that is the slowest of all internal paths. The DUMMY path is realized by connecting all the transistors of a column of the AND plane in series and by eventually using only one transistor of the OR plane if present (with all the others acting as a parasite load).

In the novel structure of the invention, all the transistors of each column of the AND plane are connected. In the Fig. 8 circuit there may be a case in which only one transistor of the OR plane is used. Therefore, the PLA of the invention surely "decides" within the time delay set by an eventual DUMMY path. In reality the PLA of the invention decides in a shorter time delay than known PLAs, because the length of the columns of the AND plane is practically halved by virtue of the fact that the number of the parasite transistors is halved (i*p rather than 2*i*p) and so is the load. Therefore, the valuation of the minterms is faster and the overall decision time is shorter.

According to the architecture of the invention, the valuation time of the AND plane is uniform, that it is equal for all the minterms, because each minterm sees the same number of transistors in series toward the power supply rail. In addition, the spread of the valuation time of the OR plane, if present, is contained. This makes possible the realization of a PLA even without any DUMMY path, that is, by using as pre-charge and valuation commands, signals purposely generated, linked to the clock that drives the PLA itself.

## Claims

1. A CMOS programmable logic array (PLA) having at least an AND plane comprising an array of transistors arranged in rows and columns, the transistors belonging to a same column being connected in series with each other, the two end current terminals of said series of transistors being coupled to the supply voltage rail (VDD) and to a reference (GND), respectively, to each row of said array with the exception of the first and the last rows are associated a first control line coupled to a first input value, a second control line coupled to the inverted logic value of said first input value and a third control line, **characterized in that**
said third control line is coupled to a voltage sufficient to keep in a state of conduction all the transistors of the row having their gate electrode connected to it;
each transistor of each row except said first and said last row has its control terminal connected to one of said three control lines associated to the row.
the transistors of the first row and of the last row of the array having their control terminals coupled to respective opposite enabling/disabling potentials (CCPA).

2. The programmable logic array (PLA) of claim 1, further comprising a column (DUMMY) of transistors, wherein the control terminals of the transistors belonging to all the rows except the first row and the last row are coupled to said third line.

## Patentansprüche

1. Programmierbares CMOS-Logikfeld (PLA) mit mindestens einer UND-Ebene, das ein Feld von Transistoren aufweist, die in Reihen und Spalten angeordnet sind, wobei die Transistoren, die zur selben Spalte gehören, zueinander in Reihe geschaltet sind, die beiden Endstromanschlüsse der Reihe von Transistoren mit der Versorgungsspannungsschiene (VDD) bzw. einer Referenz (GND) gekoppelt sind, wobei zu jeder Reihe des Feldes mit der Ausnahme der ersten und der letzten Reihen, eine erste Steuerleitung, die mit einem ersten Eingangswert gekoppelt ist, eine zweite Steuerleitung, die mit einem invertierten Logikwert des ersten Eingangswerts gekoppelt ist, und eine dritte Steuerleitung zugeordnet sind, **dadurch gekennzeichnet, daß**
die dritte Steuerleitung mit einer Spannung gekoppelt ist, die ausreicht, alle Transistoren der Reihe in einem Zustand der Leitung zu halten, deren Gate-Elektrode mit ihr verbunden ist;
bei jedem Transistor jeder Reihe mit der Ausnahme der ersten und der letzten Reihe sein Steueranschluß mit einer der drei Steuerleitungen verbunden ist, die der Reihe zugeordnet sind,
bei den Transistoren der ersten Reihe und der letzten Reihe des Feldes ihre Steueranschlüsse mit jeweiligen entgegengesetzten Freigabe-/Sperrpotentialen (CCPA) gekoppelt sind.

2. Programmierbares Logikfeld (PLA) nach Anspruch 1, das ferner eine Spalte (DUMMY) von Transistoren aufweist, wobei die Steueranschlüsse der Transistoren, die zu allen Reihen mit der Ausnahme der ersten Reihe und der letzten Reihe gehören, mit der dritten Leitung gekoppelt sind.

## Revendications

1. Réseau logique programmable (PLA) CMOS comprenant au moins un plan ET comprenant un réseau de transistors agencés en rangées et en colonnes, les transistors appartenant à une même colonne étant connectés en série, les deux bornes de courant d'extrémité de la série de transistors étant couplées au rail de tension d'alimentation (VDD) et à une référence (GND), respectivement, dans lequel, à chaque rangée du réseau sauf la première et la dernière rangée sont associées une première ligne de commande couplée à une première valeur d'entrée, une seconde ligne de commande couplée à une valeur logique inversée de la première valeur d'entrée et une troisième ligne de commande, **caractérisé en ce que** :
la troisième ligne de commande est couplée à une tension suffisante pour maintenir dans un état de conduction tous les transistors de la rangée ayant leurs électrodes de grille connectées à cette ligne de commande ;
chaque transistor de chaque rangée sauf des première et dernière rangées a sa borne de commande connectée à l'une des trois lignes de commande associées à la rangée ; et
les transistors de la première rangée et de la dernière rangée du réseau ont leur borne de commande couplée à des potentiels respectifs et opposés de validation/invalidation (CCPA).

2. Réseau logique programmable (PLA) selon la revendication 1, comprenant en outre, une colonne (DUMMY) de transistors, dans lequel les bornes de commande des transistors appartenant à toutes les rangées sauf la première rangée et la dernière rangée sont couplées à la troisième ligne.
